Europäisches Patentamt

(19) European Patent Office

Office européen des brevets

(11) Publication number: **0 140 509**
**B1**

(12) # EUROPEAN PATENT SPECIFICATION

(45) Date of publication of patent specification: **26.10.88**

(51) Int. Cl.⁴: **C 30 B 15/14,** C 30 B 27/02

(21) Application number: **84305606.0**

(22) Date of filing: **17.08.84**

(54) **An lec method and apparatus for growing single crystal.**

(30) Priority: **26.08.83 JP 154771/83**

(43) Date of publication of application:
**08.05.85 Bulletin 85/19**

(45) Publication of the grant of the patent:
**26.10.88 Bulletin 88/43**

(84) Designated Contracting States:
**DE FR GB**

(56) References cited:
**DE-A-2 107 646**
**GB-A-1 214 679**

**PATENTS ABSTRACTS OF JAPAN, vol. 7, no.
28(C-149)(1173), 4th February 1983; & JP - A -
57 183 394 (NIPPON DENSHIN DENWA KOSHA)
11-11-1982**

**PATENTS ABSTRACTS OF JAPAN, vol. 6, no.
73(C-101)(951), 8th May 1982; & JP - A - 57
11897 (SUMITOMO DENKI KOGYO K.K.) 21-01-
1982**

(73) Proprietor: **SUMITOMO ELECTRIC INDUSTRIES
LIMITED
No. 15, Kitahama 5-chome Higashi-ku
Osaka-shi Osaka 541 (JP)**

(73) Proprietor: **NIPPON TELEGRAPH AND
TELEPHONE CORPORATION
1-6 Uchisaiwaicho 1-chome Chiyoda-ku
Tokyo (JP)**

(72) Inventor: **Matsumoto, Kazuhisa c/o Itami Works
Sumitomo Electric Ind. Ltd. 1-1 Koyakita 1-
chome
Itami-shi Hyogo (JP)**
Inventor: **Morishita, Hiroshi c/o Itami Works
Sumitomo Electric Ind. Ltd. 1-1 Koyakita 1-
chome
Itami-shi Hyogo (JP)**
Inventor: **Akai, Shin-Ichi c/o Itami Works
Sumitomo Electric Ind. Ltd. 1-1 Koyakita 1-
chome
Itami-shi Hyogo (JP)**
Inventor: **Miyazawa, Shintaro
No. 7-504, 861-1 Ishida
Isehara-shi Kanagawa (JP)**

(74) Representative: **Evans, David Charles et al
F.J. CLEVELAND & COMPANY 40-43, Chancery
Lane
London, WC2A 1JQ (GB)**

Courier Press, Leamington Spa, England.

## Description

This invention relates to a liquid encapsulated Czockralski method (LEC method) for growing a GaAs single crystal by pulling up a seed crystal out of a compound melt covered with a liquid encapsulant (encapsuling material) such as $B_2O_3$.

Conventional apparatuses for growing a single crystal based on the LEC method have a single cylindrical heater with a big, uniform thickness around a crucible as a general rule.

Another LEC apparatus for growing a single crystal having a heater with a special shape was proposed in Japanese Patent Publication No. 39787/1977. Inner diameter and outer diameter of the heater cylinder vary along the axial line.

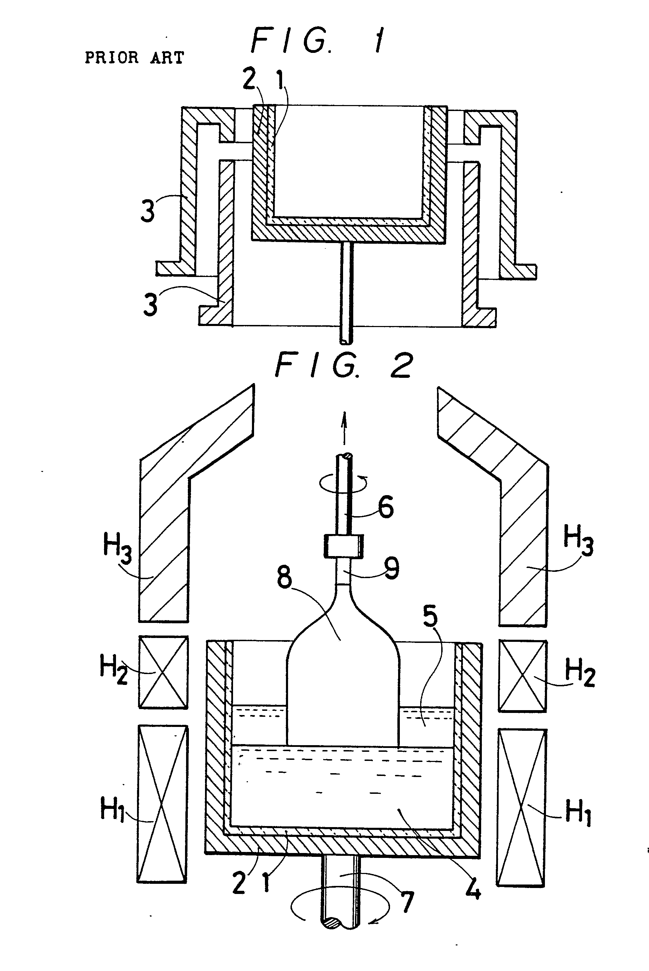

Further, another LEC apparatus having two heaters positioned vertically around a crucible was also proposed in Japanese Patent Laying Open No. 11897/1982. Fig. 1 shows a schematical sectional view of the LEC apparatus of the double heater type. In the apparatus a crucible 1 is supported by a susceptor 2, around which two heaters 3 are installed. The two heaters 3 can be displaced upwardly and downwardly independently. Temperature distribution is changed by moving the crucible 1 with the susceptor 2 and the two independent heaters 3 upwardly or downwardly.

All these improvements of the LEC method aim to realize a temperature environment suitable for crystal growth at the crystal-growing region alone. But another difficulty has not been considered.

In practice the crystal pulled up from a compound melt is cooled rapidly with non-uniform temperature distribution at a cooling zone above the crystal-growing region.

The rapid and non-uniform cooling causes the following disadvantages.

The single crystal when pulled up is cooled rapidly and irregularly by convection of a highly pressurised gas at the cooling zone above the crucible. Strong thermal stress is generated in the crystal by the non-uniform distribution of temperature.

Therefore many dislocations, lineages and another lattice defects occur in the crystal.

Even if the temperature gradient of the crystal-growing region, which is the area immediately adjacent the liquid-solid interface and the space taken up by the liquid encapsulant, is lowered to avoid rapid cooling at that region, the generation of thermal stress is not effectively suppressed. Great amounts of heat are transmitted vertically in the grown crystal emanating from the surface of the upper portion of crystal. This is because the upper portion is still exposed in a strong convection of pressurized gas. This mode of heat dissipation causes radial temperature differences between the surface and the centre on the same plane vertical to the axis.

Thus, the grown crystal is fragile and vulnerable. The crystal is apt to crack during cooling, or when the cooled crystal ingot is sliced into thin wafers then both ingot and wafers are also apt to crack.

According to the invention there is provided an LEC method for growing a single crystal of a GaAs semiconductor compound which comprises heating the compound melt in a crucible primarily utilizing a first melt heater to establish a first temperature gradient in the melt zone; heating a liquid encapsulant in the crucible primarily utilizing a crystal-growing region-controlling heater to establish a second temperature gradient in the crystal-growing region; dipping a seed crystal into the melt compound covered by molten liquid encapsulant, growing a crystal from the compound melt by pulling up and rotating the seed crystal and cooling the crystal in a cooling zone above the crucible; characterised by a cooling zone temperature-controlling means selected from a third heater and a cooling zone heat shield primarily to control the thermal environment in the uppermost portion of, and above the crucible, and further characterised by a temperature gradient in the cooling zone of 0° to 20°C/cm and which is smaller than the second temperature gradient in the crystal-growing region, which in turn is smaller than the first temperature gradient in the melt zone, whereby the growing crystal is slowly cooled under a substantially uniform temperature distribution.

The method of this invention has three temperature controlling means. The three temperature controlling means are a heater for heating the melt, a heater for controlling the thermal environment of the crystal-growing region and a heater of a heat-shield for controlling the thermal environment of the cooling zone.

The third temperature control means seeks to provide a substantially uniform (uniform or quasi-uniform) temperature distribution in the cooling zone. The grown crystal is slowly cooled in a controlled manner, with a uniform or quasi-uniform temperature distribution.

The most important matter is to control the thermal environment of the cooling zone by an independent heater or heat-shield and to cool the crystal in a uniform or quasi-uniform way.

Two different kinds of heat-shield are applicable. A big heat-shield can be installed in an outer space above the crucible, or a small heat-shield with a cylindrical shape can be floated in compound melt or liquid encapsulant. Following is a description by way of example only and with reference to the accompanying drawings of methods of carrying the invention into effect.

In the drawings:—

Fig. 1 is a schematic sectional view of a crucible and heaters of a prior art of LEC apparatus.

Fig. 2 is a schematical sectional view of the LEC apparatus for growing single crystal; using this invention.

Fig. 3 is a sectional view of another embodiment of this invention and a diagram showing the temperature distribution along the axial line at the crystal-growing region and at the cooling zone of the apparatus. Abscissa denotes temperature.

Ordinate denotes the height from the bottom of the crucible corresponding to the portion of the LEC apparatus drawn at the left side.

Fig. 4 shows sectional views of examples of heater or heat-shield for controlling thermal environment of the cooling zone. Fig. 4(A) shows a simple cylindrical heater or heat-shield. Fig. 4(B) shows a cylinder having a conical top wall inclines inward. Fig. 4(C) shows a cylinder having a flat top wall which projects inward at a right angle with the cylinder wall.

Fig. 5 is a schematical sectional view of the LEC apparatus used in the method of this invention when a single crystal is pulled up at the cooling zone.

Fig. 6(A) is a diagram showing the distributions of measured etch pit densities (EPD) on two wafers sliced from the head and tail portions of a GaAs single crystal grown using the method of this invention. Abscissa denotes the distances from the center of wafer. Ordinate denotes EPD in a logarithmic scale.

Fig. 6(B) is a diagram showing the distributions of measured etch pit densities on two wafers sliced from the head and tail portions of a GaAs single crystal grown using a conventional LEC method.

Fig. 7 is a sectional view of another embodiment in which the heat-shield, for keeping temperature of the cooling zone, is a cylinder floating on compound melt or liquid encapsulant in the crucible.

Fig. 8 is a sectional view of an example of a floating cylinder having a cavity therein.

The method for growing single crystal of this invention are explained by referring to Fig. 2.

A crucible (1) contains a compound melt (4) and a liquid encapsulant (5). A susceptor (2) sustains the crucible (1) on the bottom and side surfaces.

An upper shaft (6) is installed along an axial line from the top of the chamber (not shown) enclosing everything shown in Fig. 2. The upper shaft (6) can rotate and move up and down.

The seed crystal (9) is attached to the bottom end of the upper shaft (6). The seed crystal (9) is dipped in the compound melt (4) by lowering the upper shaft (6). Then the upper shaft (6) rotates and slowly goes upward. A single crystal (8) is grown in succession from the seed crystal (9).

The lower shaft (7) supports the susceptor (2). The lower shaft (7) can rotate and move up and down.

Heaters in the apparatus are explained.

(H1) is the heater for heating compound melt. Heater (H1) heats the crucible (1) and the compound melt (4).

(H2) is the heater for heating liquid-solid interface, liquid encapsulant and single crystal in the area immediately adjacent the liquid encapsulant. This vicinity corresponds to the crystal-growing region. The thermal environment of the crystal-growing region can be determined by controlling the power of the heater (H2). The heater (H2) is designated as the crystal-growing region-controlling heater.

(H3) is a heater for controlling the thermal environment of the space further above the liquid encapsulant (5) and the space above the crucible. The desirable thermal environment of these spaces is either a uniform distribution of temperature or quasi-uniform distribution of temperature with a small temperature gradient. These spaces define a zone in which the pulled single crystal is cooled. Then (H3) is designated as cooling-zone-temperature-controlling heater.

All the heaters are resistance heaters which generate Joule heat in proportion to current and voltage.

The melt-heating heater (H1) and the crystal-growing region-controlling heater (H2) cooperate to determine the temperature of compound melt and the thermal environment of the crystal-growing region.

An example of the thermal environments in the LEC apparatus is explained in the case of GaAs crystal growth. $B_2O_3$ is the liquid encapsulant.

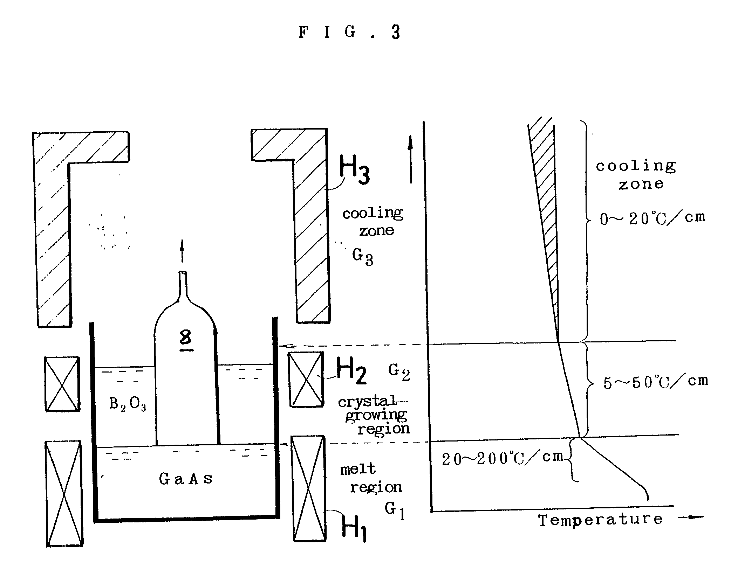

Fig. 3 shows the distribution of temperature along a vertical center axis.

As shown in the left figure of Fig. 3, the cooling-zone-temperature-controlling heater (H3) determines the thermal environment in which the single crystal is cooled after the crystal growth is ended.

The cooling zone should be a zone having a uniform distribution of temperature or a zone having a quasi-uniform distribution with a small temperature gradient.

Such a preferable thermal environment is realized mainly by controlling the cooling-zone-temperature-controlling heater (H3). However, the crystal-growing-region-controlling heater (H2) also has some influence upon the determination of the thermal environment of the cooling zone.

The right figure of Fig. 3 shows the temperature distributions.

The area held between two lines and marked with slant parallel lines denotes an allowable temperature range distribution for the cooling zone.

The crystal-growing-region-controlling heater (H2) mainly determines the thermal environment of liquid-solid interface, liquid encapsulant, and the space in the crucible above the liquid encapsulant. In GaAs crystal growth, practical range of temperature at the cooling zone should be adjusted to be 700°C to 1000°C, preferably 850°C. The temperature gradient along a vertical direction at the cooling zone must be 0 to 20°C/cm.

A single crystal pulled up to the cooling zone is cooled slowly, keeping the temperature gradient abovementioned.

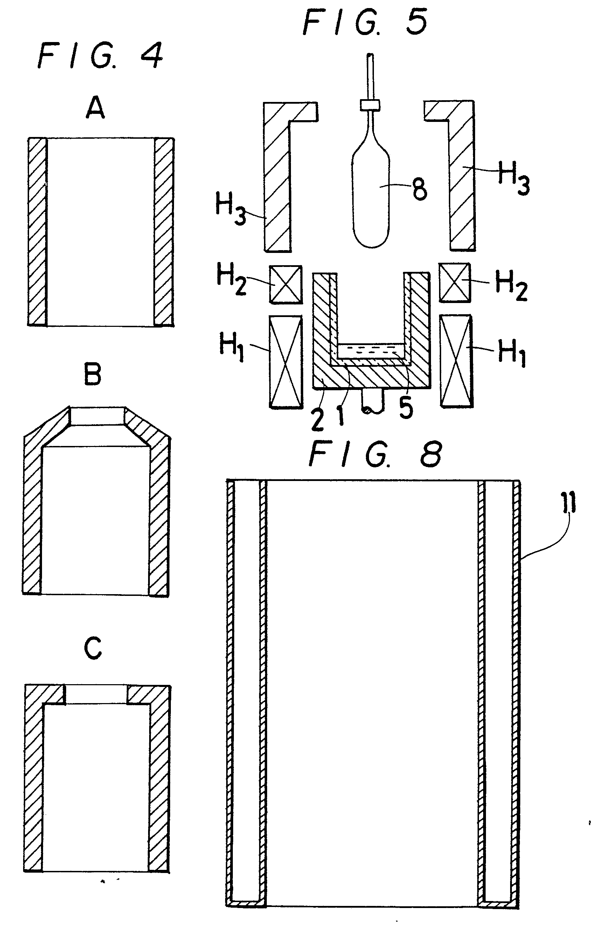

Fig. 4(A), (B) and (C) show examples of the sectional shape of cooling-zone-temperature-controlling-heater.

Fig. (A) shows a heater of a simple cylindrical shape. Both inner diameter and outer diameter are uniform along an axial direction.

Fig. (B) shows another heater of a transformed cylindrical shape having a conical top wall which inclines inwards.

Fig. (C) shows another heater of a transformed cylindrical shape having a flat top wall which projects inward at a right angle with the cylinder wall.

Heaters having the shape (B) or (C) are more preferable to form a wide zone of uniform temperatue than the heater having the shape (A).

In the above explanation H3 has been designated a heater for controlling the thermal environment of the cooling zone. However (H3) is able to be replaced by a heat-shield with a cylindrical shape.

Although a heat-shield does not heat in itself, it is sufficiently heated by the heat radiation from the other heaters (H1) and (H2) so that it can heat the cooling zone by radiating the heat obtained from (H1) and (H2). Further the heat-shield effectively suppresses convection of inert gas at the cooling zone.

Therefore a heat-shield can replace heater (H3) and can keep the thermal environment of the cooling zone as uniform or quasi-uniform as the heater (H3).

Then it can be designated as cooling-zone-heat-shield (H3).

Because the cooling-zone-heat-shield (H3) is not a heater, it is unable to control the thermal environment of the cooling zone directly. But the cooling-zone-heat-shield (H3) contributes to controlling the thermal environment of the cooling zone in an indirect manner by varying the powers of the heaters (H1) and (H2).

The shapes shown in Fig. 4(A), (B) and (C) are also fully applicable to heat-shield (H3).

Suitable materials for the heat-shield (H3) are carbon coated with BN, carbon, carbon felt, $SiO_2$, $Al_2O_3$, BN, $Si_3N_4$ and PBN. Because of the high heat conductivity, carbon is the most preferable material for the heat-shield; particularly to make a uniform temperature distribution.

The cooling-zone-heat-shield (H3) just described is fixed above the heater (H2) and has a diameter which is nearly equal to that of the crystal-growing-region-controlling-heater (H2).

Smaller heat-shields of a cylindrical shape are also applicable to a cooling-zone-heat-shield (H3). The smaller heat-shield is placed in a crucible (1) in order to enclose a single crystal (8).

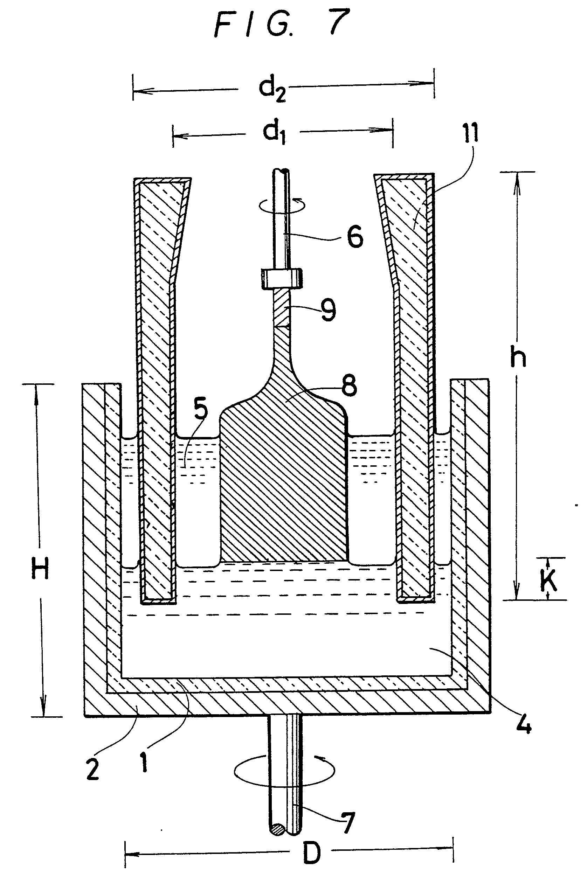

Fig. 7 shows an embodiment using a small cylinder as cooling-zone heat-shield. The heat-shield floats in a compound melt (4) and a liquid encapsulant (5).

The bottom of the heat-shield must not touch the bottom of the crucible (1) so as not to prevent the circulation of the compound melt.

Because it is floating and has cylindrical shape, the smaller heat-shield (H3) is designated floating cylinder (11).

The floating cylinder (11) may have a cylindrical sectional shape, the top portion of which inclines inwardly.

This shape effectively suppresses inert gas circulation between the inner space and the outer space of the floating cylinder (11) and reduces heat dissipation by convection.

The material of the floating cylinder is carbon coated with BN or AlN. A coating protects the compound melt and the single crystal from contamination by carbon powder.

Other suitable materials for the floating cylinder are the same as the materials of heat-shield described before.

The floating cylinder (11) must float in liquid. The top end of the floating cylinder must enclose the single crystal therein until crystal growth has preceeded to a considerable extent.

Therefore the effective specific gravity of the floating cylinder (11) must be small. A floating cylinder (11) with a cavity shown in Fig. 8 is to be preferred.

Floating cylinders can have various shapes—a cylinder with step part on the inner wall, a cylinder having a widening conical upper wall with a bigger top opening, or a cylinder having a narrowing conical upper wall with a smaller top opening.

The shape and the size of the floating cylinder are determined to adjust it to a desired thermal environment and the conditions for pulling up a crystal.

Various sizes of floating cylinders are suitable. But the upper limits and lower limits of sizes are determined according to the following formulae:—

$$0.9D < d_2 < D$$
$$0.4D < d_1 < 0.9D$$
$$0.4H < h < 1.5H$$

where $d_1$ is the inner diameter, $d_2$ is the outer diameter, h is the height of a floating cylinder, D is the inner diameter of a crucible and H is the height of the crucible (see Fig. 7).

An example of the sizes of a floating cylinder and a crucible is explained. The crucible's height H is 150 mm, and the inner diameter D is 150 mm. The floating cylinder's inner diameter $d_1$ is 102 mm, the outer diameter $d_2$ is 149 mm. And the distance k from the bottom end of the floating cylinder to the liquid-solid interface is 5 mm.

The method of the invention allows a GaAs single crystal to be pulled up through the crystal-growing-region with small temperature gradient. And the grown crystal is slowly cooled in the cooling zone having a uniform or quasi-uniform distribution of temperature.

The temperature difference in the crystal is small. The occurrence of thermal stress decreases to a considerable extent. These features result in the following advantages.

(1) Dislocations, lineages and other lattice defects decrease. Distribution of etch pit density becomes more uniform in a wafer.

(2) Probability of the occurrence of cracks in crystal during cooling process and during slicing process decreases.

(3) Because the generation of thermal stress decreases, the annealing process becomes unnecessary. This reduces the amount of work. Conventional LEC methods require an annealing process to reduce the probability of occurrence of cracks in crystals or wafers.

Example

An example of GaAs crystal production according to the invention is now described by way of illustration only. A GaAs crystal is pulled up by the LEC apparatus shown in Fig. 2. In the example (H3) is a heater

| | |
|---|---|
| Charge of GaAs | 4 Kg |
| Crucible made of PBN | 6 inches (15.24 cm) (inner diameter) |
| Inert gas | Nitrogen gas |
| Liquid encapsulant | $B_2O_3$ |

Process of crystal growth

(1) Raising the temperature of the heaters

The melt-heating heater (H1), the crystal-growing-region-controlling heater (H2) and the cooling-zone-temperature controlling heater (H3) are turned on and the temperatures of the heaters rise to the prescribed values.

4 Kg of GaAs compound melt is generated in the crucible. The compound melt is covered with a liquid encapsulant. Two atm to fifty atm ($2\times10^5$ to $5\times10^6$ Pa) of nitrogen gas fills the chamber (not shown in figures).

The necessary gas pressure depends on the thickness of $B_2O_3$ layer. When $B_2O_3$ layer is thick, even three atm ($3\times10^5$ Pa) of nitrogen gas is sufficient to press the $B_2O_3$ layer. In general, optimum range of gas pressure is 15 to 20 atm ($15\times10^5$ to $2\times10^6$ Pa).

The process for raising temperature in the case wherein starting material is polycrystalline GaAs differs from the process in the case wherein GaAs compound is directly synthesized from pure Ga and pure As.

(i) Starting material; polycrystalline GaAs.

The melt-heating heater (H1), the crystal-growing-region-controlling heater (H2) and the cooling-zone-temperature-controlling heater (H3) are turned on the same time. The temperatures of the three heaters rise in proportion to each other.

Raising the temperature of the cooling-zone-temperature-controlling heater (H3) is stopped when the temperature at a measuring point on the outer surface of the heater (H3) attains 870°C.

At that moment the temperature at a measuring point on the outer surface of the melt-heating heater (H1) is about 1200°C, and the temperature at a measuring point on the outer surface of the crystal-growing-region-controlling heater (H2) is about 1000°C. The melt-heating heater (H1) is still kept turned on. When the polycrystalline GaAs melts in the crucible, the heating of the heater (H1) is stopped. The temperature of the crystal-growing-region-controlling-heater (H2) is adjusted to be 900°C to 1100°C at the time. By an adequate choice of the adjusted temperature, arbitrary temperature gradients in the liquid-solid interface, the $B_2O_3$

liquid and the space in the vicinity of $B_2O_3$ are realized.

(ii) GaAs compound is directly synthesized from Ga and As in the crucible.

While raising the temperature of the heaters, a chemical reaction between Ga and As occurs at a high pressure (higher than 60 atm ($6\times10^6$ Pa)). GaAs compound is synthesized by the chemical reaction in a direct manner.

After the direct synthesis of GaAs finishes, the pressure of the gas is reduced and the process of raising the temperatures of heaters start again. When GaAs is molten, a compound melt is generated.

(2) Growing of crystal

Seeding is done about 30 minutes after the compound melt of GaAs is generated. A seed crystal is dipped into the compound melt.

Then crystal growth begins.

The conditions of the crystal growth are,

| | |
|---|---|
| Pulling speed | 4 to 20 mm/h (preferably 10 mm/h) |
| Rotating rate of crucible | 2 to 40 rpm (preferably 12 rpm) |
| Rotating rate of crystal | 2 to 40 rpm (preferably 10 rpm) |
| Diameter of crystal grown | 7.5 cm (3 inches) |

(3) Pulling up crystal into the cooling zone

After the crystal growth has ended, the crystal is still pulled upward into the cooling zone and is stopped there as shown in Fig. 5.

At that moment the temperature distribution in the crystal is in the range from (850°C−30°C) to (850°C+30°C).

(4) Cooling of the crystal

The crystal is slowly cooled in a uniform or quasi-uniform temperature distribution which is kept by adjusting the electric power of the heaters (H1), (H2) and (H3).

The crystal cooled to room temperature, is then detached from the LEC apparatus.

The crystal is (7,56 cm) 3 inches, in diameter.

The weight of the crystal is 3820 g, and the length is 19 cm. This crystal is a single crystal without cracks.

A GaAs single crystal of high quality is thus obtained. To clarify the effect of this invention, the single crystal is sliced into wafers and the distributions of etch pit density (EPD) in wafers are measured.

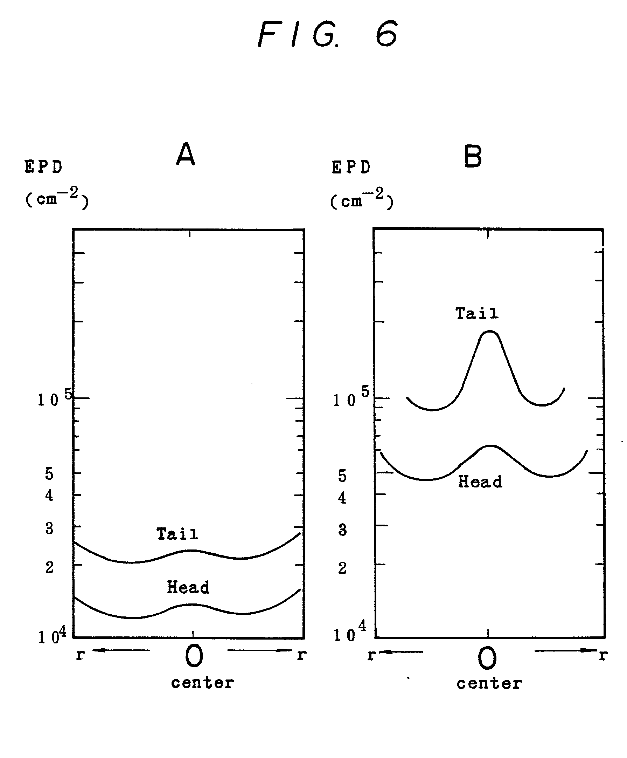

Fig. 6(A) is a diagram showing the distributions of measured etch pit density on two wafers sliced from the head and tail portions of the crystal. The Abscissa denotes the distances from the center of wafer. The Ordinate denotes EPD in a logarithmic scale.

Both distributions of EPD on the tail wafer and the head wafer are lower than $3\times10^4$ cm$^{-2}$.

Fig. 6(B) is a diagram showing the distributions of measured etch pit densities on two wafers sliced from the head and tail portions of a GaAs single crystal grown by a conventional LEC method and apparatus having only a single heater. The distributions of EPD is about $10^5$ cm$^{-2}$.

These measurements show that this invention is able to reduce EPD to about one third to one sixth the value compared with a conventional LEC method.

These single crystals made by this invention do not crack during the cooling process.

The following steps are subsequently effected on the crystal; grinding of the outer surface to adjust the diameter to within a prescribed value, and marking of orientation flats which denote the crystallographical axes.

The crystals made by this invention do not crack during these steps. The yield after grinding the outer surface to adjust the diameter to the allowable range of from 7.56 cm plus or minus 1 mm and marking orientation flats was about 33% in a conventional LEC method. But the same yield rises to 60%, with this invention.

In addition, annealing treatment after cooling becomes unnecessary, because the single crystals made by this invention do not crack. Hence the amount of work decreases.

Furthermore the EPD decreases to nearly one tenth of the aforementioned embodiment by doping more than $10^{19}$/cm$^3$ of In or Sb into the crystal.

## Claims

1. An LEC method for growing a single crystal of a GaAs semiconductor compound which comprises,

heating the compound melt in a crucible primarily utilizing a first melt heater (H1), to establish a first temperature gradient in the melt zone;

heating a liquid encapsulant in the crucible primarily utilizing a crystal-growing region-controlling heater (H2), to establish a second temperature gradient in the crystal-growing region;

dipping a seed crystal into the melt compound covered by molten liquid encapsulant, growing a crystal from the compound melt by pulling up and rotating the seed crystal;

and cooling the crystal in a cooling zone above the crucible;

characterized by a cooling zone temperature-controlling means selected from a third heater (H3) and a cooling zone heat shield (H3) primarily to control the thermal environment in the uppermost portion of, and above the crucible, and further characterised by a third temperature gradient in the cooling zone of 0 to 20°C/cm and which is smaller than the second temperature gradient in the crystal-growing region, which in turn is smaller than the first temperature gradient in the melt zone, whereby the growing crystal is slowly cooled under a substantially uniform temperature distribution.

2. An LEC method as claimed in claim 1, wherein the temperature gradient along a line extending axially of the space above the liquid encapsulant is 5°C/cm to 50°C/cm followed by a temperature gradient in the cooling zone of 0 to 20°C/cm and the temperature of the cooling zone mainly controlled by the cooling-zone-temperature-controlling means (H3) is 700°C to 1000°C.

**Patentansprüche**

1. LEC-Verfahren zum Ziehen eines Einkristalls aus einer GaAs-Halbleiterverbindung, umfassend

Erhitzen der Verbindungsschmelze in einem Schmelztiegel unter primärer Verwendung einer ersten Heizeinrichtung (H1) für die Schmelze zur Schaffung eines ersten Temperaturgradienten in der Schmelzzone,

Erhitzen eines flüssigen Einschlußmittels in dem Schmelztiegel unter primärer Verwendung einer Heizeinrichtung (H2) zur Steuerung der Kristallziehzone zur Schaffung eines zweiten Temperaturgradienten in der Kristallziehzone,

Eintauchen eines Kristallkeims in die von dem geschmolzenen flüssigen Einschlußmittel bedeckte Verbindungsschmelze, Ziehen eines Kristalls aus der Verbindungsschmelze durch Hochziehen und Drehen des Kristallkeims,

und Kühlen des Kristalls in einer Kühlzone oberhalb des Schmelztiegels, gekennzeichnet durch

eine Kühlzonentemperatursteuerungseinrichtung ausgewählt aus einer dritten Heizeinrichtung (H3) und einem Kühlzonenhitzeschild (H3), primär zur Steuerung der thermischen Umgebung im obersten Teil und oberhalb des Schmelztiegels, und ferner gekennzeichnet durch

einen dritten Temperaturgradienten in der Kühlzone von 0 bis 20°C/cm, der kleiner ist als der zweite Temperaturgradient in der Kristallziehzone, der seinerseits kleiner ist als der erste Temperaturgradient in der Schmelzzone, wodurch der gezogene Kristall unter einer im wesentlichen gleichförmigen Temperaturverteilung langsam gekühlt wird.

2. LEC-Verfahren nach Anspruch 1, bei dem der Temperaturgradient längs einer axial verlaufenden Linie des Raums oberhalb des flüssigen Einschlußmittels 5°C/cm bis 50°C/cm ist und von einem Temperaturgradienten in der Kühlzone von 0 bis 20°C/cm gefolgt wird, und bei dem die Temperatur der Kühlzone, die haptusächlich durch die Kühlzonentemperatursteuerungseinrichtung (H3) gesteuert wird, 700°C bis 1000°C beträgt.

**Revendications**

1. Procédé LEC pour faire croître un monocristal d'un composé semi-conducteur de GaAs, qui comprend

le chauffage de la masse fondue de composé dans un creuset en utilisant principalement un premier système de chauffage de la masse fondue H1, pour établir un premier gradient de température dans la zone de la masse fondue;

le chauffage d'un encapsulant liquide dans le creuset en utilisant principalement un système de chauffage contrôlant la région de croissance du cristal H2, pour établir un second gradient de température dans la région de croissance du cristal;

l'immersion d'un germe cristallin dans le composé de la masse fondue recouvert d'encapsulant liquide fondu, le développement d'un cristal à partir de la masse fondue de composé par tirage et rotation du germe cristallin;

et le refroidissement du cristal dans un zone de refroidissement au-dessus du creuset;

caractérisé par des moyens de réglage de la température de la zone de refroidissement choisis parmi un troisième système de chauffage H3 et un écran thermique de la zone de refroidissement H3 principalement pour régler l'environnement thermique dans la partie supérieure, et au-dessus du creuset, et caractérisé en outre par un troisième gradient de température dans la zone de refroidissement de 0 à 20°C/cm, qui est plus faible que le second gradient de température dans la région de croissance du cristal, lequel est à son tour plus faible que le premier gradient de température dans la zone de la masse fondue, de telle sorte que le cristal se développant est lentement refroidi avec une répartition de la température pratiquement uniforme.

2. Procédé LEC suivant la revendication 1, dans lequel le gradient de température le long d'une ligne s'étendant axialement dans l'espace au-dessus de l'encapsulant liquide est de 5°C/cm à 50°C/cm, suivi par un gradient de température de la zone de refroidissement de 0 à 20°C/cm, et la température de la zone de refroidissement principalement réglée par le moyen de réglage de la température dans la zone de refroidissement H3 est de 700°C à 1000°C.

## F I G. 1

PRIOR ART

## F I G. 2

F I G . 3

cooling
zone
G₃

H₃

cooling
zone

$0 \sim 20°C/cm$

H₂   G₂

crystal-
growing
region

B₂O₃

GaAs

melt
region
G₁

H₁

$5 \sim 50°C/cm$

$20 \sim 200°C/cm$

Temperature ⟶

FIG. 4

A

FIG. 5

$H_3$      8      $H_3$

$H_2$      $H_2$

$H_1$      $H_1$

2 1  5

B

FIG. 8

11

C

0 140 509

# FIG. 6

0 140 509

# F I G. 7

5